# EUROPEAN PATENT APPLICATION

(11) **EP 2 206 800 A1**
(43) Date of publication of application: **14.07.2010**
(21) Application number: 09180326.2
(22) Date of filing: 22.12.2009
(51) Int. Cl.: C23C 14/02, C23C 14/06, F16D 69/02

(54) **Slide member**

(30) Priority: 26.12.2008 JP 2008333078
(71) Applicant: Hitachi Ltd., Tokyo 100-8280 (JP)
(72) Inventor: Okamoto, Shinya, Tokyo Tokyo 100-8220 (JP); Baba, Noboru, Tokyo Tokyo 100-8220 (JP); Okamoto, Kazutaka, Tokyo Tokyo 100-8220 (JP)
(74) Representative: MERH-IP Matias Erny Reichl Hoffmann

(57) **Abstract**

An object of the present invention is to provide a slide member with a hard carbon coating having excellent wear resistance, low friction performance and excellent corrosion resistance.

An aluminum alloy 101 covered with an alumina layer is used as a substrate 2, and an electric conductive layer 4, a buffer layer 5 and a diamondlike carbon layer 7 are formed on the substrate 2 in the above-listed order from the substrate side.

## Description

### TECHNICAL FIELD:

The present invention relates to a slide member.

### BACKGROUND ART:

Diamondlike carbon films (DLC films) generally have features of a high hardness, a smooth surface, and excellent rub resistance. And the DLC films have a low coefficient of friction and excellent low friction properties attributed to their solid lubricating properties. Under unlubricated condition, a surface friction coefficient is 0.5 or higher for a smooth surface of typical steel and approximately 0.4 for conventional surface treatment materials such as a nickel-phosphorus plating (Ni-P plating), chromium plating (Cr plating), titanium nitride coating (TiN coating) and chromium nitride coating (CrN coating); while DLC films have a surface friction coefficient of approximately 0.1.

Currently, DLC films are applied to a lot of slide members used under unlubricated condition such as cutting instruments including a drill blade, jigs for grinding tools, dies for deforming process, valve cocks or capstan rollers by utilizing these excellent characteristics. Meanwhile, oil lubricated sliding members are now dominant in machine components such as those used in an internal combustion engine, which is required to reduce mechanical loss as much as possible in the viewpoint of energy consumption and environmental considerations.

Document 1 (Japanese Patent Laid-open No. 2005-108355) discloses a magnetic head using a DLC film as a protective film.

Document 2 (Japanese Patent Laid-open No. 2001-107860) discloses a slide member in which a diamondlike carbon coating film is formed on a substrate of aluminum alloy with an undercoating layer interposed therebetween; the undercoating layer comprises a plurality of compound layers containing carbon, nitrogen and a transition metal and having different composition, and the plurality of layers are laminated so that the hardness gradually decreases from the topmost layer comprising the diamondlike carbon coating film towards the substrate.

Document 3 (Japanese Patent Laid-open No. 2006-300294) discloses a retainer for ball bearing having a DLC coating formed on its outermost layer.

In conventional cases, however, using a steel substrate as, for example, a slide member for automobile increases the weight of the automobile. Therefore, there has been possibility for improvement in a point that an attempt to reduce the load on a slide portion by forming a hard carbon coating on the slide member could hardly increase the efficiency of the entire automobile. When the hard carbon coating for the steel substrate is formed on an aluminum alloy substrate whose surface is covered with an alumina layer (a bonding layer and a diamondlike carbon layer are formed directly on the alumina layer), a bias voltage cannot be applied to the substrate in forming the hard carbon coating since the alumina layer is an electrical insulating layer. Accordingly, adhesion of the hard carbon coating to the substrate cannot be obtained, resulting in failure of load reduction of the slide portion.

An object of the present invention is to provide a slide member using an Al alloy substrate having a hard carbon coating with low friction property, high wear resistance and corrosion resistance in the field of industrial instruments such as automobiles of which a weight reduction is required from the perspective of environmental considerations.

### SUMMARY OF THE INVENTION:

The slide member of the present invention comprises a substrate formed of an aluminum alloy covered with an alumina layer; an electric conductive layer; a buffer layer; and/or a diamondlike carbon layer, wherein the electric conductive layer, the buffer layer and the diamondlike carbon layer are formed on the substrate in the above-listed order from the substrate side. The buffer layer can improve the adhesion to the substrate and supplement hardness of the substrate.

Furthermore, a method for producing a slide member comprising a substrate formed of an aluminum alloy covered with an alumina layer comprises a step of forming an electric conductive layer on the surface of the substrate by the sputtering method or the ion plating method; and/or a step of forming a buffer layer on the electric conductive layer, forming a gradient layer on the buffer layer, and forming a diamondlike carbon layer on the gradient layer in a state that a bias voltage is applied to the substrate.

The present invention can provide a slide member using an aluminum alloy as a substrate and having a hard carbon coating with low friction property and excellent wear resistance and corrosion resistance.

### BRIEF DESCRIPTION OF THE DRAWINGS:

Fig. 1 is a schematic cross-section view illustrating a slide member of an embodiment of the present invention.
Fig. 2 is a schematic cross-sectional view illustrating a substrate and a hard carbon coating of Comparative Example 1.
Fig. 3 is a schematic cross-sectional view illustrating a substrate and a hard carbon coating of Comparative Example 2.
Fig. 4 is a graph showing the film formation conditions in Example 1 according to the present invention.
Fig. 5 is a graph showing the film formation conditions in Example 2 according to the present invention.
Fig. 6 is a graph showing the film formation conditions in Example 3 according to the present invention.
Fig. 7 is a graph showing the film formation conditions in Comparative Examples.
Fig. 8 is a cross-sectional view illustrating a brake piston for automobile of an embodiment of the present invention.

### DETAILED DESCRIPTION OF THE PREFERRED EMBODIMENTS:

The present invention relates to a slide member having a hard carbon coating with low friction and excellent wear resistance and corrosion resistance.

Embodiments of the present invention will be described below, but the present invention is not limited to the embodiments shown below. The hard carbon coating shown in this embodiment can be applied to slide members (Al alloy substrates) such as machine components used under unlubricated condition. The hard carbon coating (hereinafter referred to as "coating") can be formed by performing the unbalanced magnetron sputtering method (UBM method) on the substrate.

In the UBM method, a balance of magnetic poles arranged at a back surface of a target is intentionally shifted between a center of the target and a fringing part thereof and it is made to be in a non-equilibrium state, thereby a part of magnetic lines from a magnetic pole at the fringing part of the target can be extended to the substrate. It is therefore more likely for plasma centralized in the vicinity of the target to diffuse to the neighborhood of the substrate along the magnetic lines. Therefore, an ion content irradiated to the substrate during the formation of the coating can be increased. As a result, it is possible to form a dense coating over the substrate. The UBM method is a deposition method comprising the above processes.

The diamondlike carbon layer contains aluminum, and the amount contained is preferably 0.5 to 4.5 at.% though its details will be described with reference to Examples. Herein, at.% is an atomic percent, and is the percentage thereof relative to the number of atoms of constituent elements in the material (in this case, in the diamondlike carbon layer).

It is preferable that the state of aluminum contained in the diamondlike carbon layer is any one of metal, boride, carbide, nitride, oxide or hydroxide. It is preferable that sp² bonding carbon and sp³ bonding carbon coexist in the diamondlike carbon layer.

The electric conductive layer preferably contains an element selected from aluminum (Al), chromium (Cr) and titanium (Ti).

The buffer layer preferably contains a nitride selected from chromium nitride and titanium nitride. A gradient layer may be provided between the buffer layer and the diamondlike carbon layer.

When the gradient layer is provided, it is preferable that the gradient layer is a carbon-metal composition (a mixture of a carbon and a metal) or a metal carbide; the amount of metal contained in the gradient layer decreases from the substrate side towards the outermost layer side; and the amount of carbon contained in the gradient layer increases from the substrate side towards the outermost layer side. The metal is preferably one element selected from aluminum, chromium and titanium.

When another gradient layer is provided, it is preferable that the gradient layer is a carbon-metal composition or a metal carbide; the amount of the first metal contained in the gradient layer decreases from the substrate side towards the outside; and the amount of the second metal and carbon contained in the gradient layer increases from the substrate side towards the outside. The first metal is preferably a metal selected from the group consisting of aluminum, chromium and titanium. The second metal is preferably a selected from the group consisting of aluminum, chromium and titanium, and is preferably a metal different from the first metal.

The slide member mentioned above is preferably used as, for example, a brake piston for automobile.

The present invention will be described below with reference to Examples.

### [Example 1]

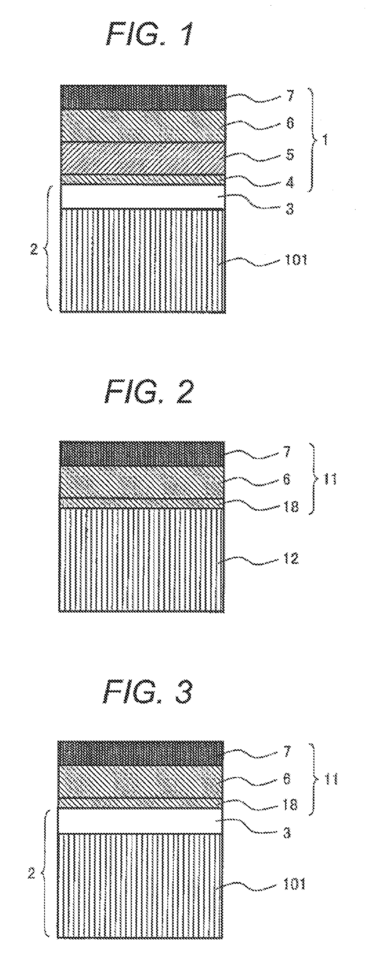

Fig. 1 is a cross-sectional view of a slide member showing an embodiment of the present invention.

In Fig. 1, the slide member is formed of a substrate 2 constituted by an aluminum alloy 101 and anodized coating 3 covering a surface of the aluminum alloy 101, and a coating 1 comprising an electric conductive layer 4, a buffer layer 5, a gradient layer 6 and a diamondlike carbon layer 7 in order from the substrate 2 side towards the outside.

Herein, the aluminum alloy 101 is an AI-Mg-Si-based alloy, JIS A6061-T6. The coating 1 is formed by the UBM method.

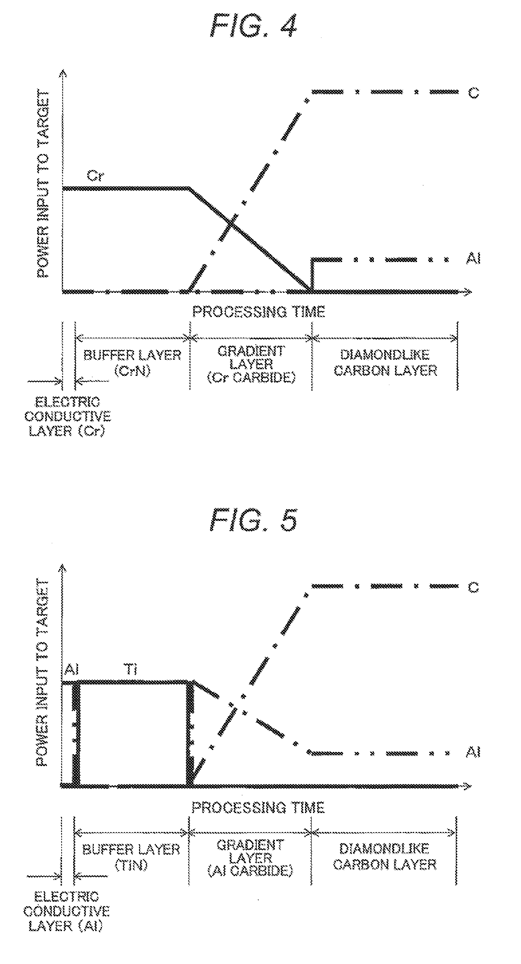

Specifically, the coating 1 is formed under the conditions (process time vs. power input to target) shown in Fig. 4.

First, the electric conductive layer 4 containing chromium (Cr) as a main component is formed while introducing an inert gas without applying a bias voltage.

Second, the buffer layer 5 containing chromium nitride (CrN) as a main component is formed while introducing an inert gas and nitrogen gas and applying a bias voltage.

Furthermore, the gradient layer 6 is formed while introducing an inert gas and hydrocarbon gas and applying a bias voltage.

In forming the gradient layer 6, a chromium carbide layer is formed first, and then a chromium target power is controlled to gradually decrease, and a carbon target power is controlled to gradually increase. There are several types of chromium carbides which constitute the chromium carbide layer, such as Cr₃C₂, Cr₇C₃ and Cr₂₃C₆, but they are not limited to these types.

Finally, the diamondlike carbon layer 7 is formed while introducing an inert gas and hydrocarbon gas and applying a bias voltage so that the amount of aluminum (Al) contained is 1.88 at.%.

In the above process, forming the electric conductive layer 4 on the surface of the substrate 2 can change the surface of the substrate 2 having an electrically isolative property into a conductive surface, and allows formation of the buffer layer 5, gradient layer 6 and diamondlike carbon layer 7.

In general, the harder a base such as the substrate 2 is, the better an adhesion of the hard carbon coating. Herein, the coating 1 denotes a stacked film comprising the electric conductive layer 4, buffer layer 5, gradient layer 6, and diamondlike carbon layer 7.

The buffer layer 5 denotes a layer for improving the adhesion between the diamondlike carbon layer 7 and the substrate 2 and supplementing the hardness of the substrate 2 in forming the coating 1 on the substrate 2 formed of a soft Al alloy as in this Example. The buffer layer 5 preferably has hardness higher than the substrate 2, and hardness lower than or as high as the diamondlike carbon layer 7. In this Example, since the buffer layer 5 containing CrN can supplement the hardness of the substrate 2 comprising a soft Al alloy, the adhesion of the diamondlike carbon layer 7 becomes high.

Since the gradient layer 6 exists between the buffer layer 5 and diamondlike carbon layer 7, the adhesion of the diamondlike carbon layer 7 can be further improved.

An appropriate amount of Al element contained in the diamondlike carbon layer 7 can lower frictional coefficient under unlubricated condition. Furthermore, since pinholes in the anodized coating 3 on the surface of the substrate 2 can be sealed with the coating 1, corrosion resistance can be improved compared with the substrate 2 exposed.

As already mentioned, according to the present invention, a slide member having low friction property and excellent wear resistance and corrosion resistance can be provided. When the slide member of the present invention is applied to automobiles, a weight reduction of the automobile as a whole can be realized since an Al alloy substrate is used as the substrate 2. As a result, highly efficient automobiles can be provided.

In this Example, the electric conductive layer 4, buffer layer 5 and gradient layer 6 comprise Cr, CrN and Cr carbide, respectively, but they are not limited to these examples, and similar effects can be obtained by using Ti or Al, TiN, and titanium carbide in the electric conductive layer 4, buffer layer 5 and gradient layer 6, respectively. Furthermore, the buffer layer 5 may be formed of titanium carbide or chromium carbide (Cr₃C₂, Cr₇C₃, Cr₂₃C₆, etc.).

In the diamondlike carbon layer 7 in this Example, sp² combined carbon which is a carbon bonding represented by graphite coexists with sp³ combined carbon which is a carbon bonding represented by diamond. As a result, the coating 1 having low friction property, wear resistance and corrosion resistance can be provided. Generally, a DLC film contains a carbon of an amorphous state or a hydrogenated carbon, and it is called an amorphous carbon or hydrogenated amorphous carbon (a-C: H). The plasma CVD method for deposition by a plasma decomposition of a hydrocarbon gas, a gas-phase synthesis method such as an ion beam deposition using carbon and hydrocarbon ions, the ion plating method for deposition by evaporating graphite or the like using arc-discharge, and the sputtering method for deposition by sputtering a target in an inert gas atmosphere are used for the formation of the DLC film.

The coating 1 formed in this Example has low friction properties, high wear resistance and corrosion resistance, and can be applied to a slide member. Accordingly, this can provide a slide member capable of reducing load under unlubricated condition as well as under water, organic solvent, fuel and oil lubricated condition. In addition, a machine component normally sliding in a lubricating oil can maintain its reliability even when the lubricating oil runs short, thus reducing the amount of lubricating oil.

In this Example, JIS A6061-T6 is used as the substrate 2. Since its aging temperature is about 160 to 180°C, it is necessary to set temperature conditions so that the temperature of the coating 1 during its formation is not higher than the aging temperature to suppress the softening of the substrate 2.

In the formation of the coating 1 of the present invention, the buffer layer 5 containing CrN and the anodized coating 3 on the surface of the substrate 2 are formed. In order to increase the adhesion between the substrate 2 and the buffer layer 5, the electric conductive layer 4 is preferably formed between the substrate 2 (anodized coating 3) and the buffer layer 5.

In the gradient layer 6 formed between the buffer layer 5 and diamondlike carbon layer 7, it is preferable that a Cr carbide layer is formed first, and the concentration of Cr continuously decreases, and, the concentration of C continuously increases from the buffer layer 5 side towards the diamondlike carbon layer 7 side. In addition, when Cr carbide which is a material constituting the gradient layer 6 is represented by CrₓC_{y}, it is preferable that its chemical composition is changed gradually from the buffer layer 5 side towards the diamondlike carbon layer 7 side by changing the ratio of x to y gradually.

The coating 1 having good adhesion can be provided by designing the structure from the substrate 2 to the diamondlike carbon layer 7 as described above.

It is preferable that the coating 1 is formed by the sputtering or ion plating method. In addition, this coating 1 contains Al element in the diamondlike carbon layer 7. Its amount contained is 0.5 to 4.5 at.%, and preferably 0.6 to 1.9 at.%. While the state of aluminum contained in the diamondlike carbon layer is selected from the group consisting of metal, boride, carbide, nitride, oxide and hydroxide, it is preferable that aluminum is contained in the form of oxide and/or hydroxide. Accordingly, the coating 1 having both wear resistance and low friction property can be provided. The coating 1 formed by this Example has high adhesion, wear resistance and low friction property, and can be thus imparted to slide members. Accordingly, this can provide a slide member capable of reducing load under unlubricated condition as well as under water, organic solvent, fuel and oil lubricated condition. In addition, a machine component normally sliding in a lubricating oil can maintain its reliability even when the lubricating oil runs short, thus reducing the amount of lubricating oil.

Al exposed on the surface of the coating 1 reacts with oxygen, water or the like in the atmosphere to form an Al oxide or Al hydroxide, thereby also providing a dielectric coating with stable electrical properties although it contains metal. As a result, Al contained in such a coating 1 is present on the surface of the coating 1 in the form of Al oxide and/or Al hydroxide. That is, the surface of the coating 1 (in particular, the surface of the diamondlike carbon layer 7) has hydrophilicity, thereby enabling realization of low friction properties in a water lubricated sliding. This also permits realization of low friction properties in a sliding under the presence of liquid or steam having the same OH-group as water (e.g., alcohols or additives in oil).

This Example is extremely desirable in terms that the presence of Al in the coating 1 reduces its internal stress, thereby improving the adhesion between the diamondlike carbon layer 7 and gradient layer 6, and rendering the coating 1 less likely to be peeled away from the substrate 2.

However, when the amount of Al element contained in the diamondlike carbon layer 7 is lower than 0.5 at.%, the diamondlike carbon layer 7 contains less amount of Al oxide and/or Al hydroxide from which the hydrophilicity is derived, and thus cannot be expected to produce a friction reducing effect.

It was found from the result of X-ray photoelectron spectroscopy (XPS) that there was possibility of progress of Al carbides formation in case Al content on the surface and inside of the diamondlike carbon layer 7 is more than 5 at.%. That is, since the diamondlike carbon layer 7 having an Al content more than 5 at.% produces more Al carbides, it is undesirable to make the diamondlike carbon layer 7 more prone to cracking due to the embrittlement of the Al carbides.

In case Al element used in the diamondlike carbon layer 7 is present in the form of Al oxide and/or Al hydroxide, since the layer has high affinity to liquid or steam with OH-groups, the layer can give the slide member low friction properties.

In this Example, since the coating 1 is formed by the sputtering or ion plating method, Al can be added to the diamondlike carbon layer 7 by using an Al target. The target application of this Example is parts for automobiles for which weight reduction is required, for instance, components like brake piston mechanisms which require low friction properties, high wear resistance and corrosion resistance. Because a bias voltage can be applied in forming the buffer layer 5, gradient layer 6 and diamondlike carbon layer 7 by forming the electric conductive layer 4 on the substrate 2 formed of an Al alloy whose surface is covered with the anodized coating 3, all of the coating 1 can be given a good adhesion to the substrate 2. Since the buffer layer 5 contains CrN, and it functions as a layer for supplementing the hardness of the substrate 2 in case the diamondlike carbon layer 7 is formed on the soft substrate 2 formed of an Al alloy, the adhesion of the diamondlike carbon layer 7 to the substrate 2 can be improved.

The concentration of chromium (the concentration of Cr) is decreased and the concentration of carbon (the concentration of C) is increased from the buffer layer 5 side towards the diamondlike carbon layer 7 side, and Al element is caused to contain the diamondlike carbon layer 7, thereby high adhesion of the entire coating 1 to the substrate 2 can be realized. This allows the slide member to be used under unlubricated condition as well as under water, organic solvent, fuel and oil lubricated condition.

### [Example 2]

The coating 1 shown in Fig. 1 is formed by the UBM method on the substrate 2 made of JIS A6061-T6, i.e. an Al-Mg-Si-based alloy, covered with the anodized coating 3.

Specifically, the coating 1 is formed under the conditions (process time vs. power input to target) shown in Fig. 5.

First, the electric conductive layer 4 containing Al is formed while introducing an inert gas without applying a bias voltage. Second, the buffer layer 5 containing TiN is formed while introducing the inert gas and nitrogen gas and applying the bias voltage. Furthermore, the gradient layer 6 is formed while introducing the inert gas and hydrocarbon gas and applying the bias voltage.

In forming the gradient layer 6, first, the Al carbide layer is formed, and the Al target power is then controlled to gradually decrease to the Al target power in the diamondlike carbon layer 7, and a carbon target power is controlled to gradually increase. Finally, the diamondlike carbon layer 7 is formed while introducing the inert gas and hydrocarbon gas and applying the bias voltage so that the amount of Al element contained is 1.88 at.%.

Since forming the electric conductive layer 4 on the surface of the substrate 2 can change the surface of the substrate 2 having an electrically isolative property into a conductive surface thereby, the buffer layer 5, gradient layer 6 and the diamondlike carbon layer 7 can be formed.

The buffer layer 5 preferably has hardness higher than the substrate 2, and hardness lower than or as high as the diamondlike carbon layer 7. In this Example, since the hardness of the substrate 2 formed of the soft Al alloy can be supplemented by the buffer layer 5 containing TiN, the adhesion of the diamondlike carbon layer 7 becomes high. The presence of the gradient layer 6 between the buffer layer 5 and diamondlike carbon layer 7 can further improve the adhesion of the diamondlike carbon layer 7. Furthermore, an appropriate amount of Al element contained in the diamondlike carbon layer 7 can lower frictional coefficient under unlubricated condition. Furthermore, since pinholes in the anodized coating 3 on the surface of the substrate 2 can be sealed with the coating 1, corrosion resistance is improved compared with the substrate 2 exposed.

As mentioned above, the present invention can provide a slide member having low friction property and excellent wear resistance and corrosion resistance. Moreover, in case the slide member of the present invention is applied to automobiles, the weight reduction of the automobile as a whole is realized since Al alloy is used in the substrate 2, and as a result, highly efficient automobiles can be provided.

In this Example, although the electric conductive layer 4 comprises Al and the buffer layer 5 comprises TiN, they are not limited to these examples, and similar effects can be obtained by using Cr or Ti and CrN in the electric conductive layer 4 and buffer layer 5, respectively.

### [Example 3]

The coating 1 shown in Fig. 1 is formed on the substrate 2 comprising JIS A6061-T6 of an Al-Mg-Si-based alloy and the anodized coating 3 covering the surface thereof using the UBM method.

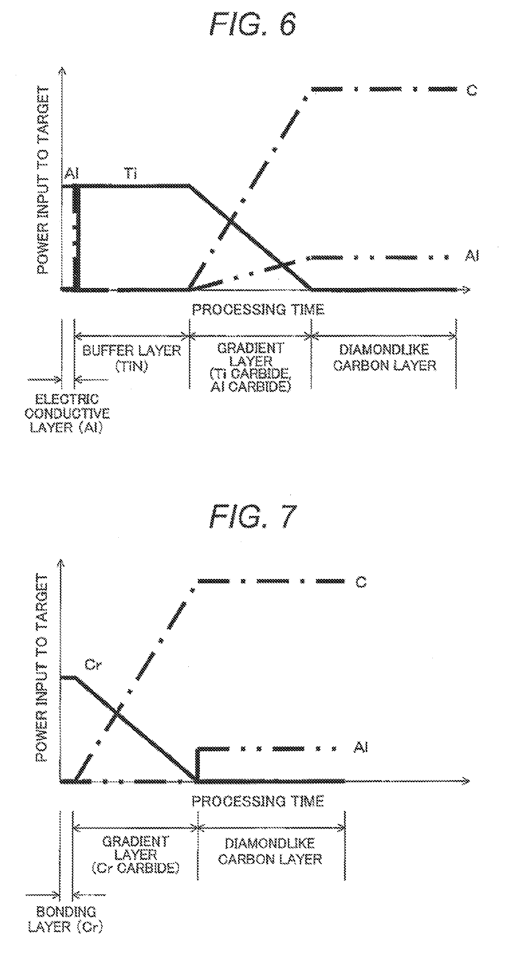

Specifically, the coating 1 is formed under the conditions (process time vs. power input to target) shown in Fig. 6.

First, the electric conductive layer 4 containing Al is formed while introducing an inert gas, without applying a bias voltage. Second, the buffer layer 5 containing TiN is formed while introducing the inert gas and nitrogen gas and applying the bias voltage. Furthermore, the gradient layer 6 is formed while introducing the inert gas and hydrocarbon gas and applying the bias voltage.

In forming the gradient layer 6, first, the Ti carbide layer is formed, and then Ti target power is controlled to gradually decrease, and carbon target power and Al target power are controlled to gradually increase. Finally, the diamondlike carbon layer 7 is formed while introducing the inert gas and hydrocarbon gas and applying the bias voltage so that the amount of Al element contained is 1.88 at.%.

Forming the electric conductive layer 4 on the surface of the substrate 2 can change the surface of the substrate 2 having an electrically isolative property into a conductive surface, and allows formation of the buffer layer 5, gradient layer 6 and the diamondlike carbon layer 7.

The buffer layer 5 preferably has hardness higher than the substrate 2, hardness lower than or as high as the diamondlike carbon layer 7. In this Example, the hardness of the substrate 2 containing soft Al alloy can be supplemented by the buffer layer 5 containing TiN, and the adhesion of the diamondlike carbon layer 7 therefore becomes good. The presence of the gradient layer 6 between the buffer layer 5 and diamondlike carbon layer 7 can further improve the adhesion of the diamondlike carbon layer 7. Furthermore, an appropriate amount of Al element contained in the diamondlike carbon layer 7 can lower frictional coefficient under unlubricated condition. In addition, since pinholes in the anodized coating 3 on the surface of the substrate 2 can be sealed with the coating 1, corrosion resistance is improved compared with the substrate 2 exposed.

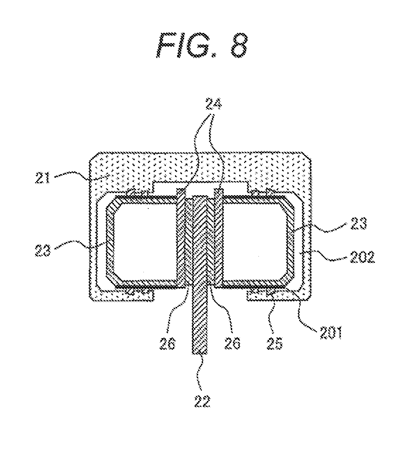

Fig. 8 is a cross-sectional view of a brake piston for an automobile showing an example of the present invention.

The brake piston in Fig. 8 is for a two-wheeled vehicle. A brake operates and stops the rotation of a wheel by nipping a disk rotor 22 rotating coaxially with the wheel between inner brake pads 26 out of two sets of brake pads 24, 26 from both side. This figure is a longitudinal sectional view seen from a direction parallel to a rotational direction of the wheel and disk rotor 22, and the rotational direction of the disk rotor 22 is perpendicular to the paper describing this figure.

In this figure, pistons 23, brake pads 24, 26 and a seal 25 are accommodated inside of a cylinder bore 21. The seal 25 is arranged between the cylinder bore 21 and pistons 23, so that oil 202 sealed within the cylinder bore 21 does not leak out. The pressure of the oil 202 applied to the right and left pistons 23 moves the right and left pistons 23 inwardly, which brings the brake pads 26 and disk rotor 22 into contact.

The slide member of the present invention is the piston 23, and a coating 201 of the present invention is provided on a surface that the piston 23 and the seal 25 come into contact. This coating 201 can lower the friction between the piston 23 and the seal 25, suppress wearing and improve corrosion resistance.

Herein, any coating of the slide members of Examples 1 to 3 mentioned above can be applied to the coating 201. Furthermore, a coating applied to a brake piston for automobile is not limited to Examples 1 to 3, and any coating can be applied as long as it meets the constituent features of the slide member of the present invention.

As mentioned above, according to the present invention, a slide member having low friction property, excellent wear resistance and corrosion resistance can be provided. Moreover, when this is applied to a slide member for automobiles (piston for break of automobile), the weight reduction of the automobile is realized as a whole since an Al alloy is used as the substrate 2, and as a result, automobiles with even higher efficiencies can be provided.

In this Example, although the electric conductive layer 4 and the buffer layer 5 comprise TiN and Al respectively, they are not limited to these examples, and similar effects can be obtained by using Cr or Ti and CrN in the electric conductive layer 4 and buffer layer 5 respectively.

### (Comparative Example 1)

The coating 11 shown in Fig. 2 is formed on the substrate 12 made of an alloy (chrome molybdenum steel) containing Fe, Cr and Mo by the UBM method.

Specifically, the coating 11 is formed under the conditions (process time vs. power input to target) shown in Fig. 7.

A bonding layer 18 containing Cr is formed, while introducing an inert gas and then applying a bias voltage. Thereafter, the gradient layer 6 is formed while introducing the inert gas and hydrocarbon gas and applying the bias voltage.

In forming the gradient layer 6, first, the Cr carbide layer is formed, and then Cr target power is controlled to gradually decrease, and a carbon target power is controlled to gradually increase. Finally, the diamondlike carbon layer 7 is formed while introducing an inert gas and hydrocarbon gas and applying a bias voltage so that the amount of Al element contained is 1.88 at.%.

Herein, the bonding layer 18 is a layer introduced for improving adhesion mainly between the substrate 12 and the gradient layer 6. The bonding layer 18 and gradient layer 6 can improve the adhesion of the diamondlike carbon layer 7. Furthermore, an appropriate amount of Al element contained in the diamondlike carbon layer 7 can lower frictional coefficient under unlubricated condition. When this is applied to the slide member, a slide member having low friction property and excellent wear resistance can be provided. However, when this is used for a slide member for automobiles, the weight reduction of the automobile as a whole cannot be realized since a steel substrate is used as the substrate 12, and as a result, a highly efficient automobile cannot be provided.

### (Comparative Example 2)

The coating 11 shown in Fig. 3 is formed on the substrate 2 comprising an aluminum alloy 101 (Al-Mg-Si-based alloy), JIS A6061-T6, and the anodized coating 3 covering the surface thereof by the UBM method.

Specifically, the coating 11 is formed under the conditions (process time vs. power input to target) shown in Fig. 7.

First, the bonding layer 18 containing Cr is formed while introducing an inert gas and applying a bias voltage. Second, the gradient layer 6 is formed while introducing the inert gas and a hydrocarbon gas and applying the bias voltage.

In forming the gradient layer 6, a Cr carbide layer is formed first, and then Cr target power is controlled to gradually decrease, and a carbon target power is controlled to gradually increase. Finally, the diamondlike carbon layer 7 is formed while introducing an inert gas and hydrocarbon gas and applying a bias voltage so that the amount of Al element contained is 1.88 at.%. However, since the bias voltage is not appropriately applied during formation of the bonding layer 18, the bonding layer 18 is not appropriately formed, resulting in lowered adhesion of the gradient layer 6 and the diamondlike carbon layer 7. Therefore, frictional coefficient cannot be lowered under unlubricated condition, and a low friction property and excellent wear resistance cannot be obtained even if this is applied to the slide member.

According to the present invention, low friction properties can be achieved in machine components by using DLC films having excellent solid lubricating properties under unlubricated condition, the load of the oil lubricated machine components can reduce even when the lubricating oil on the sliding member runs short. In addition, applying the present invention also is preferable in the viewpoint of environmental considerations because consumption of the lubricating oil can be reduced.

According to the present invention, light-metal alloys such as aluminum alloys can be effectively used for slide members for automobiles, and performance of the slide members made of the light-metal alloys can be improved.

Further, according to the present invention, a weight reduction of components for automobiles and a higher efficiency of automobiles can be achieved.

The present invention relates to a slide member with a hard carbon coating having low friction, excellent wear resistance and corrosion resistance, and is applicable in particular to pistons for brakes used to be slid against rubber under unlubricated condition, and parts for automobiles such as engine components used under lubricated condition.

Features, components and specific details of the structures of the above-described embodiments may be exchanged or combined to form further embodiments optimized for the respective application. As far as those modifications are apparent for an expert skilled in the art they shall be disclosed implicitly by the above description without specifying explicitly every possible combination.

## Claims

1. A slide member comprising:
a substrate (2) formed of an aluminum alloy (101) covered with an alumina layer;
an electric conductive layer (4);
a buffer layer (5); and
a diamondlike carbon layer (7),
wherein the electric conductive layer (4), the buffer layer (5) and the diamondlike carbon layer (7) are formed on the substrate (2) in the above-listed order from the substrate side.

2. The slide member according to claim 1, wherein the diamondlike carbon layer (7) contains aluminum.

3. The slide member according to claim 1 or 2, wherein the electric conductive layer (4) contains a metal selected from the group consisting of aluminum, chromium and titanium.

4. The slide member according to at least one of claims 1 to 3, wherein the buffer layer (5) contains a nitride selected from the group consisting of chromium nitride and titanium nitride.

5. The slide member according to at least one of claims 1 to 3, wherein the buffer layer (5) contains a carbide selected from the group consisting of chromium carbide and titanium carbide.

6. The slide member according to at least one of claims 1 to 5, wherein a gradient layer (6) is provided between the buffer layer (5) and the diamondlike carbon layer (7).

7. The slide member according to claim 6, wherein the gradient layer (6) is a carbon-metal composition or a metal carbide; an amount of metal contained in the gradient layer (6) decreases from the substrate side towards the outside; an amount of carbon contained in the gradient layer (6) increases from the substrate side towards the outside; and the metal is a metal selected from the group consisting of aluminum, chromium and titanium.

8. The slide member according to claim 6, wherein the gradient layer (6) is a carbon-metal composition or a metal carbide; an amount of a first metal contained in the gradient layer (6) decreases from the substrate side towards the outside; an amount of a second metal and carbon contained in the gradient layer (6) increases from the substrate side towards the outside; the first metal is a metal selected from the group consisting of aluminum, chromium and titanium; and the second metal is a metal selected from the group consisting of aluminum, chromium and titanium, and is different from the first metal.

9. The slide member according to at least one of claims 2 to 8, wherein an amount of aluminum contained in the diamondlike carbon layer (7) is 0.5 to 4.5 at.%.

10. The slide member according to at least one of claims 2 to 9, wherein a state of aluminum contained in the diamondlike carbon layer (7) is a state selected from the group consisting of metal, boride, carbide, nitride, oxide and hydroxide.

11. The slide member according to at least one of claims 1 to 10, wherein both of sp² bonding carbon and sp³ bonding carbon are contained in the diamondlike carbon layer (7).

12. A brake piston for automobile constituted by the slide member according to at least one of claims 1 to 11.

13. A method for producing a slide member comprising a substrate (2) formed of an aluminum alloy (101) covered with an alumina layer, the method comprising the steps of:
forming an electric conductive layer (4) on a surface of the substrate (2) by the sputtering method or the ion plating method; and
forming a buffer layer (5) on the electric conductive layer (4), forming a gradient layer (6) on the buffer layer (5), and forming a diamondlike carbon layer (7) on the gradient layer (6) in a state that a bias voltage is applied to the substrate (2).

14. The method according to claim 13, wherein the diamondlike carbon layer (7) contains aluminum.

## Amended claims

### Amended claims in accordance with Rule 137(2) EPC.

**1.** A brake piston for an automobile constituted by a slide member comprising:
a substrate (2) formed of an aluminum alloy (101) covered with an alumina layer;
an electric conductive layer (4);
a buffer layer (5); and
a diamondlike carbon layer (7),
wherein the electric conductive layer (4), the buffer layer (5) and the diamondlike carbon layer (7) are formed on the substrate (2) in the above-listed order from the substrate side.

**2.** The brake piston according to claim 1, wherein the diamondlike carbon layer (7) contains aluminum.

**3.** The brake piston according to claim 1 or 2, wherein the electric conductive layer (4) contains a metal selected from the group consisting of aluminum, chromium and titanium.

**4.** The brake piston according to at least one of claims 1 to 3, wherein the buffer layer (5) contains a nitride selected from the group consisting of chromium nitride and titanium nitride.

**5.** The brake piston according to at least one of claims 1 to 3, wherein the buffer layer (5) contains a carbide selected from the group consisting of chromium carbide and titanium carbide.

**6.** The brake piston according to at least one of claims 1 to 5, wherein a gradient layer (6) is provided between the buffer layer (5) and the diamondlike carbon layer (7).

**7.** The brake piston according to claim 6, wherein the gradient layer (6) is a carbon-metal composition or a metal carbide; an amount of metal contained in the gradient layer (6) decreases from the substrate side towards the outside; an amount of carbon contained in the gradient layer (6) increases from the substrate side towards the outside; and the metal is a metal selected from the group consisting of aluminum, chromium and titanium.

**8.** The brake piston according to claim 6, wherein the gradient layer (6) is a carbon-metal composition or a metal carbide; an amount of a first metal contained in the gradient layer (6) decreases from the substrate side towards the outside; an amount of a second metal and carbon contained in the gradient layer (6) increases from the substrate side towards the outside; the first metal is a metal selected from the group consisting of aluminum, chromium and titanium; and the second metal is a metal selected from the group consisting of aluminum, chromium and titanium, and is different from the first metal.

**9.** The brake piston according to at least one of claims 2 to 8, wherein an amount of aluminum contained in the diamondlike carbon layer (7) is 0.5 to 4.5 at.%.

**10.** The brake piston according to at least one of claims 2 to 9, wherein a state of aluminum contained in the diamondlike carbon layer (7) is a state selected from the group consisting of metal, boride, carbide, nitride, oxide and hydroxide.

**11.** The brake piston according to at least one of claims 1 to 10, wherein both of sp² bonding carbon and sp³ bonding carbon are contained in the diamondlike carbon layer (7).

**12.** A method for producing a brake piston for an automobile constituted by a slide member comprising a substrate (2) formed of an aluminum alloy (101) covered with an alumina layer, the method comprising the steps of:
forming an electric conductive layer (4) on a surface of the substrate (2) by the sputtering method or the ion plating method; and
forming a buffer layer (5) on the electric conductive layer (4), forming a gradient layer (6) on the buffer layer (5), and forming a diamondlike carbon layer (7) on the gradient layer (6) in a state that a bias voltage is applied to the substrate (2).

**13.** The method according to claim 12, wherein the diamondlike carbon layer (7) contains aluminum.
